# EUROPÄISCHE PATENTANMELDUNG

(11) **EP 0 797 376 A2**
(43) Veröffentlichungstag der Anmeldung: **24.09.1997**
(21) Anmeldenummer: 97103671.0
(22) Anmeldetag: 06.03.1997
(51) Int. Cl.: H05B 33/14

(54) **Elektrolumineszierende Anordnungen unter Verwendung von Blendsystemen**

(30) Priorität: 19.03.1996 DE 19610723
(71) Anmelder: BAYER AG, 51368 Leverkusen (DE)
(72) Erfinder: Wehrmann, Rolf, Dr., 47800 Krefeld (DE); Elschner, Andreas, Dr., 45479 Mülheim (DE); Michaelis, Stephan, Dr., 51519 Odenthal (DE); Thurm, Siegfried, Dr., 40668 Meerbusch (DE); Claussen, Uwe, Dr., 51379 Leverkusen (DE); Egerer, Gerhard, 92724 Trabitz (DE); Karg, Siegfried, Dr., 91807 Solnhofen (DE)

(57) **Zusammenfassung**

Gegenstand der Erfindung sind elektrolumineszierende Anordnungen, die mindestens 2 Elektroden, die Basiselektrode 2 und die Topelektrode 8 und eine die lichtemittierende Schicht 5, die einen Farbstoff der Formel (I) und/oder (II) enthält, enthalten:

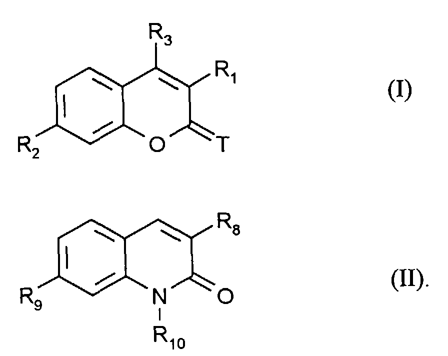

## Beschreibung

Eine elektrolumineszierende (EL) Anordnung ist dadurch charakterisiert, daß sie unter Anlegung einer elektrischen Spannung unter Stromfluß Licht aussendet. Derartige Anordnungen sind unter der Bezeichnung "Leuchtdioden" (LEDs = light emitting diodes) seit langem in der Technik bekannt. Die Emission von Licht kommt dadurch zustande, daß positive Ladungen ("Löcher", holes) und negative Ladungen ("Elektronen", electrons) unter Aussendung von Licht rekombinieren.

Bei der Entwicklung lichtemittierender Bauteile für Elektronik oder Photonik kommen heute hauptsächlich anorganische Halbleiter, wie Galliumarsenid, zum Einsatz. Auf Basis derartiger Substanzen können punktförmige Anzeigeelemente hergestellt werden. Großflächige Anordnungen sind nicht möglich.

Neben den Halbleiterleuchtdioden sind elektrolumineszierende Anordnungen auf Basis aufgedampfter niedermolekularer organischer Verbindungen bekannt (US-P 4 539 507, US-P 4 769 262, US-P 5 077 142, EP-A 406 762). Auch mit diesen Materialien können - bedingt durch das Herstellverfahren - nur kleindimensionierte LEDs hergestellt werden. Außerdem besitzen diese elektrolumineszierenden Anordnungen nur sehr geringe Lebensdauern.

Weiterhin werden Polymere, wie Poly-(p-phenylene) und Poly-(p-phenylenvinylene (PPV)) als elektrolumineszierende Polymere beschrieben: G. Leising el al., Adv. Mater. 4 (1992) No. 1; Friend et al., J. Chem. Soc., Chem. Commun. 32 (1992); Saito et al., Polymer, 1990, Vol. 31, 1137; Friend et al., Physical Review B, Vol. 42, No. 18, 11670 oder WO 90/13148. Weitere Beispiele für PPV in Elektrolumineszenzanzeigen werden in EP-A 443 861, WO-A-9203490 und 92003491 beschrieben.

EP-A 0 294 061 stellt einen optischen Modulator auf Basis von Polyacetylen vor.

Zur Herstellung flexibler Polymer-LEDs haben Heeger at al. lösliche konjugierte PPV-Derivate vorgeschlagen (WO 92/16023).

Polymerblends unterschiedlicher Zusammensetzung sind ebenfalls bekannt: M. Stolka et al., Pure & Appl. Chem., Vol. 67, No. 1, pp. 1775-182, 1995; H. Bässler et al., Adv. Mater. 1995, 7, No. 6, 551; K. Nagai et al., Appl. Phys. Lett. 67 (16), 1995, 2281; EP-A 532 798.

Die organischen EL-Anordnungen enthalten in der Regel eine oder mehrere Schichten aus organischen Ladungstransportverbindungen. Der prinzipielle Aufbau in der Reihenfolge der Schichten ist wie folgt:
- 1: Träger, Substrat
- 2: Basiselektrode
- 3: Löcher-injizierende Schicht
- 4: Löcher-transportierende Schicht
- 5: Licht-emittierende Schicht
- 6: Elektronen-transportierende Schicht
- 7: Elektronen-injizierende Schicht
- 8: Topelektrode
- 9: Kontakte
- 10: Umhüllung, Verkapselung.

Dieser Aufbau stellt den allgemeinsten Fall dar und kann vereinfacht werden, indem einzelne Schichten weggelassen werden, so daß eine Schicht mehrere Aufgaben übernimmt. Im einfachsten Fall besteht eine EL-Anordung aus zwei Elektroden, zwischen denen sich eine organische Schicht befindet, die alle Funktionen - inklusive der der Emission von Licht - erfüllt. Derartige Systeme sind z.B. in der Anmeldung WO 90/13148 auf der Basis von Poly-(p-phenylenvinylen) beschrieben.

Der Aufbau von Mehrschichtsystem kann durch Aufdampfverfahren, bei denen die Schichten sukzessive aus der Gasphase aufgebracht werden oder durch Gießverfahren erfolgen. Gießverfahren sind aufgrund der höheren Prozeßgeschwindigkeiten bevorzugt. Allerdings stellt der Anlöseprozeß einer bereits aufgebrachten Schicht beim Überschichten mit der nächsten Schicht eine Schwierigkeit dar.

Es besteht die Aufgabe, Blendsysteme auf Basis von Fluoreszenzfarbstoffen und geeigneten Bindern zum Aufbau von Ein- und Mehrschichtanordnungen bereitzustellen.

Es wurde nun gefunden, daß Fluoreszenzfarbstoffe der unten angegebenen allgemeinen Formel (I) und (II) in transparenten Thermoplasten dispergiert und durch Gießverfahren zu Schichtsystemen verarbeitet werden können.

Gegenstand der Erfindung sind elektrolumineszierende Anordnungen, die mindestens 2 Elektroden, die Basiselektrode 2 und die Topelektrode 8 und eine die lichtemittierende Schicht 5, die einen Farbstoff der Formel (I) und/oder (II) enthält, enthalten: 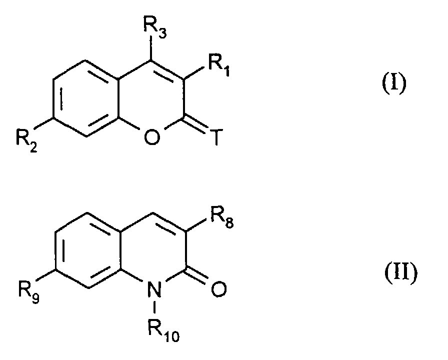 wobei
- T: für Sauerstoff oder NR₄ steht,
wobei
- R₄: für Wasserstoff, gegebenenfalls substituiertes Alkyl oder gegebenenfalls substituiertes Aryl steht;
- R₁ und R₈: ein über ein C-Atom gebundener carbo- oder heterocyclischer 5- oder 6-gliedriger Ring oder ein über ein N-Atom gebundener 5- oder 6-gliedriger heterocyclischer Ring bedeutet, der zu einer durch die Cumarin-N-Heterocyclus gelegten Achse rotationsunsymmetrisch ist, wobei die genannten 5- oder 6-gliedrigen Ringe nicht-ionogene Substituenten tragen können und an sie ein gegebenenfalls substituierter Benzol- oder ein gegebenenfalls substituierter Naphthalinring ankondensiert sein kann;
- R₂ und R₉: gegebenenfalls substituiertes Alkyl, Alkenyl, gegebenenfalls substituiertes Cycloalkyl, gegebenenfalls substituiertes Aryl, gegebenenfalls substituiertes Aralkyl bedeutet oder für -O-R₅ oder für 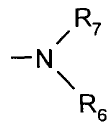 steht, wobei
- R₅, R₆, R₇ oder R₁₀: gleich oder verschieden sein können und für Wasserstoff, gegebenenfalls substituiertes Alkyl oder gegebenenfalls substituiertes Aryl stehen.
- R₃: für H oder CN sieht.
- R₁ und R₈: stehen bevorzugt für einen 5- oder 6-gliedrigen heterocyclischen Ring, der 1, 2 oder 3 Heteroatome aus der Reihe N, O, S enthält und an den ein Benzolring ankondensiert sein kann, wobei sowohl der heterocyclische Ring wie auch der ankondensierte Benzolring durch beispielsweise Alkyl, Aryl, Aralkyl, Cycloalkyl, Halogen, Alkoxy, Cyan und Acyl substituiert sein können.

Als Beispiele für R₁ bzw. R₈ in der Bedeutung eines 5- oder 6-gliedrigen heterocyclischen Ringes an den ein Benzolring ankondensiert sein kann, seien genannt: Pyrazol, Imidazol, Thiazol, Oxazol, 1,2,4-Triazol, 1,3,4-Oxadiazol, 1,3,4-Thiadiazol, Benzimidazol, Benzthiazol, Benzoxazol, Pyridin.

Besonders bevorzugt stehen R₁ und R₈ für einen heterocyclischen Rest der Formel 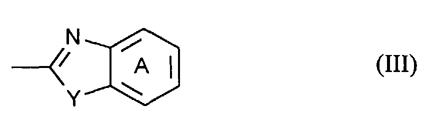 in der
- Y: Sauerstoff, Schwefel oder NR¹¹ bezeichnet, wobei
- R¹¹: für Wasserstoff, Alkyl, Aryl, Cycloalkyl oder Aralkyl sieht und der Ring A durch vorzugsweise 1 bis 2 Substituenten aus der Reihe C₁-C₄-Alkyl, C₁-C₄-Alkoxy, Brom, Chlor, Phenyl, Cyclohexyl, C₁-C₄-Alkylsulfonyl, Sulfamoyl oder C₁-C₄-Alkoxycarabonyl substituiert sein kann.

Alkyl (R₅, R₆, R₇, R₁₀, R₁₁ und als nicht-ionogener Substituent der 5- oder 6-gliedrigen Ringe gemäß R₁ und R₈) steht bevorzugt für C₁-C₆-Alkyl.

Alkenyl (R₅, R₆, R₇, R₁₀) steht bevorzugt für C₂-C₇-Alkenyl, insbesondere Allyl.

Aryl (R₅, R₆, R₇, R₁₁ und als nicht-ionogener Substituent der 5- oder 6-gliedrigen Ringe R₁) steht bevorzugt für Phenyl.

Cycloalkyl (R₅, R₆, R₇, R₁₀, R₁₁ und als nicht-ionogener Substituent der 5- oder 6-gliedrigen Ringe gemäß R₁ und R₈) steht bevorzugt für C₃-C₇-Cycloalkyl, besonders bevorzugt für Cyclohexyl.

Aralkyl (R₅, R₆, R₇, R₁₀, R₁₁ und als nicht-ionogener Substituent der 5- oder 6-gliedrigen Ringe R₁) steht bevorzugt für Benzyl und Phenethyl.

Acyl (R₁ und R₈) steht bevorzugt für (C₁-C₆-Alkyl)-carbonyl, Benzoyl, C₁-C₆-Alkylsulfonyl und Phenylsulfonyl.

Halogen als nicht-ionogener Substituent der 5- oder 6-gliedrigen Ringe gemäß R₁ und R₈ steht bevorzugt für Chlor, Brom und Fluor.

Alkoxy als nicht-ionogener Substituent der 5- oder 6-gliedrigen Ringe gemäß R₁ und R₈ steht bevorzugt für C₁-C₆-Alkoxy.

Substituiertes Alkyl (R₅, R₆, R₇, R₁₀, R₁₁, R₄) steht für Alkyl, das beispielsweise durch Halogen wie Chlor und Brom, Hydroxyl, Cyan, Trifluormethyl, C₁-C₆-Alkoxy, C₁-C₆-Alkylsulfonyl, Phenylsulfonyl, durch C₁-C₆-Alkyl und Phenyl mono- und disubstituiertes Carbamoyl, Sulfamoyl, durch C₁-C₆-Alkyl und Phenyl mono- und disubstituiertes Sulfamoyl und durch C₁-C₆-Phenyl mono- oder disubstituiertes Amino, substituiert sein kann.

Substituiertes Aryl (R₅, R₆, R₇, R₁₀, R₁₁, R₄) substituiertes Cycloalkyl (R₂ und R₉) und substituiertes Aralkyl (R₂ und R₉) steht für Aryl, Cycloalkyl oder Aralkyl, (R₂ und R₉) steht für Aryl, Cycloalkyl oder Aralkyl, die neben den vorstehend für Alkyl genannten Substituenten beispielsweise noch durch C₁-C₆-Alkyl substituiert sein können.

Bevorzugt als lichtemittierende Farbstoffe sind Farbstoffe der Formeln 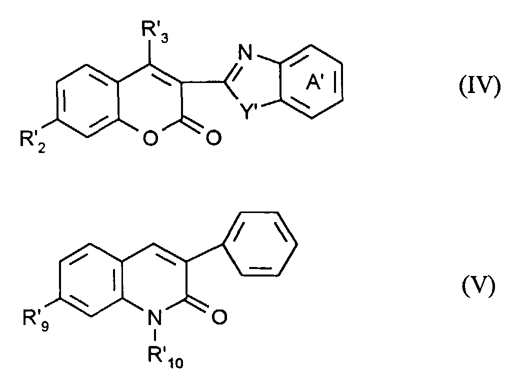 in denen
- R'₂: C₁-C₄-Dialkylamino, insbesondere Dimethylamino und Diethylamino,
- R'₃: H oder CN
- Y': O, NR'₅ oder S bezeichnen, wobei
- R'₅: C₁-C₄-Alkyl, insbesondere Methyl oder Phenyl bezeichnet und
- der Ring A': durch C₁-C₄-Alkyl, insbesondere Methyl, C₁-C₄-Alkoxy, insbesondere Methoxy, Halogen, insbesondere Chlor, Alkylsulfonyl, insbesondere Methylsulfonyl und Sulfamoyl substituiert sein kann.

Beispiele für Farbstoffe sind

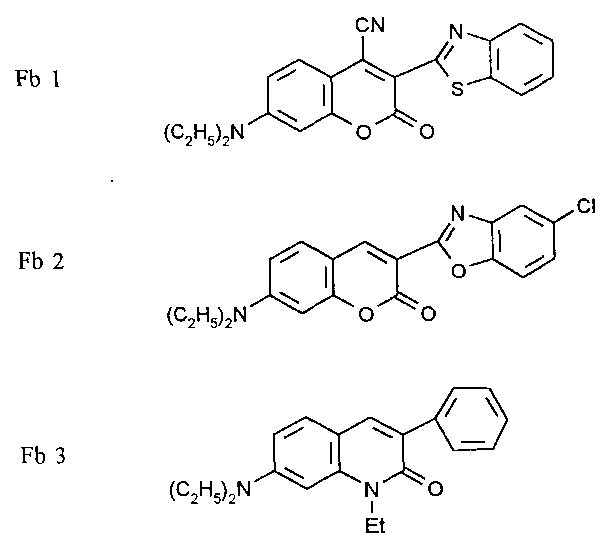

Erfindungsgemäß werden unter Ladungstransportverbindungen alle Verbindungen verstanden, die in irgendeiner Art und Weise Löcher und/oder Elektronen transportieren. Darunter fallen auch ausdrücklich diejenigen Verbindungen, die Bestandteile der Emitter-Schicht sind, also photolumineszierende Materialien darstellen, wie z.B. Fluoreszenzfarbstoffe oder Phenylaminderivate bzw. allgemeine tertiäre Amine.

In der Literatur wird eine Vielzahl von organischen Verbindungen beschrieben, die Ladungen (Löcher und/oder Elektronen) transportieren. Verwendet werden überwiegend niedermolekulare Substanzen, die z.B. im Hochvakuum aufgedampft werden. Meistens handelt es sich um tert. Arylamine oder Oxadiazolgruppenhaltige Verbindungen. Einen guten Überblick über die Substanzklassen und ihre Verwendung geben z.B. die Veröffentlichungen EP-A-387 715, US-P 4 539 507, 4 720 432 und 4 769 292. Im Prinzip kann man z.B. alle Substanzen verwenden, die als Photoleiter aus der Elektrophotographie bekannt sind. Eine umfassende Beschreibung von Lochleitern und Elektronenleitern ist in EP-A-532 798 gegeben.

Besonders geeignet als ladungstransportierende Substanzen sind Polythiophene oder Mischungen mit Polythiophenen, die in EP 0 686 662 beschrieben sind.

Zur Formulierung der elektrolumineszierenden Schicht werden die photolumineszierenden Farbstoffe in einem löslichen transparenten Binder dispergiert.

Als inerte Binder werden vorzugsweise lösliche transparente Polymere wie z.B. Polycarbonate, Polystyrol und Copolymere des Polystyrols wie SAN, Polysulfone, Polymerisat auf Basis von Vinylgruppen-haltigen Monomeren wie z.B. Polyacrylate, Polyvinylcarbazol, Polyvinylpyrrolidon, Vinylacetat- und Vinylalkoholpolymere und -copolymere Polyolefine, Phenoxyharze usw. eingesetzt. Diese inerten Binder kommen auch als Bindemittel für die elektronenleitenden und/oder lochleitenden Materialien in Frage. Eine umfassende Darstellung geeigneter polymerer Binder ist in EP-A 532 798 gegeben.

Die Blends aus dem Fluoreszenzfarbstoff und dem inerten Binder zeichnen sich u.a. dadurch aus, daß sie filmbildend sind und durch Gießen, Rakeln oder Spin-coating auf geeignete Träger mit einer leitfähigen Schicht aufgebracht werden können.

Zum Aufbau einer elektrolumineszierenden Anordnung wird eine geeignete Kombination aus einem oder mehreren Fluoreszenzfarbstoffen und einem transparenten Binder in einem geeigneten Lösemittel eingestellt und die Lösung durch bekannte Verfahren - Gießen, Rakeln, Spin-coating - auf die transparente Elektrode aufgebracht.

Dieser Lösung können weiter Substanzen, gegen Luft, Thermooxidation, Ozon und UV-Strahlung wirksame Stabilisatoren, lochleitende und/oder elektronenleitende Verbindungen vor der Schichtherstellung zugesetzt werden.

Im Gegensatz zu einer solchen Mehrkomponentenmischung ist es aber auch möglich, lochleitende und elektronenleitende Materialien in separaten Schichten, gegebenenfalls auch noch zusätzlich, anzuordnen. In diesem Fall wird die lochleitende Substanz, bei der es sich um polymere Verbindungen, Oligomere oder um Monomere, die in einem polymeren Binder dispergiert sind, handeln kann, auf die transparente Elektrode durch Gieß- oder Aufdampfverfahren aufgebracht. Diese Schicht wird im nächsten Schritt mit dem Blend aus Fluoreszenzfarbstoff und Binder überschichtet. Analog kann die elektronenleitende Schicht separat auf die lichtemittierende Schicht aufgebracht werden. Dazu wird der Elektronenleiter, wobei es sich um ein Polymer oder ein in einem Binder dispergierten Oligomer oder Monomere handeln kann, in einem geeigneten Lösemittel gelöst und auf die lichtemittierende Schicht gegossen oder aufgedampft.

Es ist auch möglich, Lochleiter und Fluoreszenzfarbstoff in einem Blend und den Elektronenleiter als separate Schicht aufzubringen. Weiterhin kann auch erst eine separate Schicht eines Lochleiters aufgebracht werden, die mit einem Blend aus Fluoreszenzfarbstoff und Elektronenleiter überschichtet wird.

Die Konzentration des Fluoreszenzfarbstoffs im Blend mit dem polymeren Binder ist im Bereich von 2 bis 85 Gew.-% variierbar; bevorzugt beträgt der Gehalt 5 bis 75 Gew.-%, besonders bevorzugt 10 bis 70 Gew.-%.

Der Gehalt an niedermolekularem Lochleiter in einem polymeren Binder ist im Bereich von 2 bis 85 Gew.-% variierbar; bevorzugt beträgt der Gehalt 5 bis 75 Gew.-%, besonders bevorzugt 10 bis 70 Gew.-%. Filmbildende Lochleiter können auch in reiner Form (100 %ig) eingesetzt werden.

Der Gehalt an niedermolekularen Elektronenleitern in polymeren Bindern ist im Bereich von 2 bis 85 Gew.-% variierbar; bevorzugt beträgt der Gehalt 5 bis 75 Gew.-%, besonders bevorzugt 10 bis 70 Gew.-%. Filmbildende Elektronenleiter können auch in reiner Form (100 %ig) eingesetzt werden.

Als transparenter Träger wird z.B. Glas oder Kunststoffmaterial, z.B. eine Folie aus Polyethylenterephthalat, Polyethylennaphthalat, Polycarbonat, Polysulfon oder Polyimid verwendet.

Als Elektrodenmaterial sind beispielsweise geeignet:
a) Metalloxide, z.B. Indium-Zinn-Oxid (ITO), Zinnoxid (NESA), etc.,
b) semi-transparente Metallfilme, z.B. Au, Pt, Ag, Cu etc.,
c) leitfähige Polymerfilme wie Polyaniline, Polythiophene, etc.

Die Metalloxid- und die semitransparenten Metallfilmelektroden werden durch Techniken wie Aufdampfen, Aufsputtern, Platinierung, etc., in dünner Schicht aufgebracht.

Eine der Elektroden ist in der Regel im sichtbaren Spektralbereich transparent.

Die Dicke der transparenten Elektrode beträgt 50 Å bis etwa mehrere µm, vorzugsweise 100 Å bis 5000 Å.

Die elektrolumineszierende Substanz wird direkt auf die transparente Elektrode oder auf eine gegebenenfalls vorhandene ladungstransportierende Schicht als dünner Film aufgebracht. Die Dicke des Films beträgt 30 Å bis 10 µm, vorzugsweise 50 Å bis 1 µm.

Nach dem Trocknen der EL-Schicht und der gegebenenfalls aufgebrachten elektronenleitenden Schicht werden diese mit einer Gegenelektrode ausgerüstet. Diese besteht aus einer leitfähigen Substanz, die transparent sein kann.

Die erfindungsgemäße Anordnung wird durch zwei elektrische Zuführungen (z.B. Metalldrähte) mit den beiden Elektroden in Kontakt gebracht.

Die Anordnungen emittieren beim Anlegen einer Gleichspannung im Bereich bis 100 Voll Licht der Wellenlänge von 400 bis 700 nm. Sie zeigen im Bereich von 400 bis 700 nm Photolumineszenz.

Die erfindungsgemäßen Blendsysteme zeichnen sich durch hohe Quantenausbeuten und geringen Einsatzspannungen für die Elektrolumineszenz aus. Mit ihnen lassen sich unterschiedliche Elektrolumineszenzfarben herstellen.

Die erfindungsgemäßen Blendsysteme können in Displays zur Beleuchtung und zur Informationsdarstellung eingesetzt werden.

### Beispiele

Zum Aufbau der elektrolumineszierenden Anordnungen werden die Farbstoffe Fb 1, Fb 2 und Fb 3 eingesetzt.

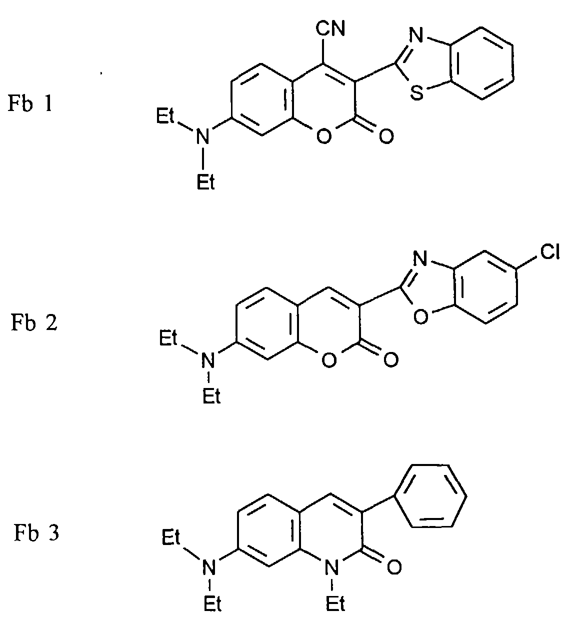

Als Träger der Schichtsysteme (Ein- und Zweischichtsysteme) der polymeren LEDs dienen Glassubstrate der Firma Balzers, Baltracon Z 20. Die Substrate werden bereits mit ausgesputtertem transparentem, leitfähigem Indium-Zinn-Oxid (ITO) geliefert. Nach Reinigung der ITO-Oberfläche mit Aceton und Methanol werden hier Lösungen der polymeren Materialien mit einem Spin-Coater der Firma Hamatech, Typ HS 485, mit definierten Drehzahlen aufgeschleudert.

### Beispiele 1 bis 3

Zusammensetzung der Blends und Herstellung der lichtemittierenden Schicht

### Beispiel 1

Niedermolekularer Fluoreszenzfarbstoff Fb 1 (30 Gew.-%) im Blend mit dem polymeren Binder Polyvinylcarbazol (PVK) (70 Gew.-%). Beide werden in Dichlorethan 0,5 %ig gelöst und mit einem 0,45 µm Filter filtriert. Nach dem Pipettieren der Lösung auf die ITO-Anode wird das Substrat bei definierter Drehzahl über eine Zeitspanne von 30 Sekunden am Spin-Coater gedreht. Die roten Blend-Filme ergeben eine Schichtdicke von 110 nm (bei 500 U/min) bzw. 35 nm (bei 1000 U/min).

### Beispiel 2

Cumarinfarbstoff Fb 2 (30 Gew.-%) im Blend mit dem polymeren Binder Polyvinylcarbazol (PVK) (70 Gew.-%). Beide werden in Dichlorethan 0,5 %ig gelöst und mit einem 0,45 µm Filter filtriert. Hier ergeben 500 bzw. 1000 U/min am Spin-Coater Schichtdicken der grünen Blend-Filme von 150 nm bzw. 80 nm.

### Beispiel 3

Niedermolekularer Fluoreszenzfarbstoff Fb 3 (30 Gew.-%) im Blend mit dem polymeren Binder Polyvinylcarbazol (PVK) (70 Gew.-%). Beide werden in Dichlorethan 0,5 %ig gelöst und mit einem 0,45 µm Filter filtriert. Am Spin-Coater eingestellte 500 bzw. 1500 U/min ergeben Schichtdicken dieser blauen Blend-Filme von 150 nm bzw. 80 nm.

Nach dem Aufschleudern der Emitterschichten werden die beschichteten Substrate stets für mindestens 2 h in einem Vakuumofen bei einem Druck von 10⁻³ mbar und einer Temperatur von 50°C zwischengelagert, um ein vollständiges Abdampfen der Lösungsmittel zu gewährleisten.

### Herstellung von Zweischichtanordnungen mit dem Oxadiazol PBD in polymeren Bindern als Elektronenleiter

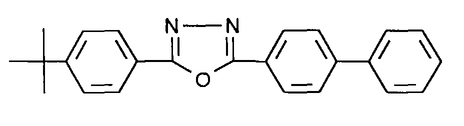

Als polymere Elektronentransport-Schicht im Zweischichtaufbau wird das 2-(4-Biphenyl)-5-(4-tert.-butylphenyl)-1,3,4-oxadiazol (PBD) im Blend mit Polystyrol (PS) im Verhältnis von zwei Teilen PBD und einem Teil PS verwendet. Die zum Spin-Coaten verwendete Lösung ist 0,5 %ig in Ethylacetat bzw. in Tetrahydrofuran (THF) und mit einem 0,45 µm Filter filtriert. Diese zweite Schicht im Mehrschichtaufbau wird mit 1500 U/min aufgeschleudert, was eine zusätzliche Dicke von ca. 40 nm ergab.

Das Aufbringen der Kathode erfolgt jeweils bei einem Druck von ca. 10⁻⁷ mbar in einer Aufdampfanlage der Firma Leybold, Univex 450, wobei als Deckelektrode Aluminium (A1) verwendet wurde.

Die Charakterisierung der Einschicht- bzw. Zweischicht-PLEDs erfolgte an rechnergesteuerten Meßplätzen, an denen die Diodenkennlinien, Spektren der Photolumineszenz und Elektrolumineszenz gemessen wurden.

Alle Anordnungen zeigen Lichtemission beim Anlegen einer elektrischen Spannung

**Tabelle 1**

| Materialien | Einsatzspannung (V) | Maxima der PL (nm) | Maxima der EL (nm) |
|---|---|---|---|
| Fb 1 /PVK | 3 | 593 | 626 |
| Fb 1 / PVK + PBD/PS | 13 | 583 | 592 |
| Fb 2 / PVK | 18 | 532 | 522 |
| Fb 2 / PVK+ PBD/PS | 13 | 480 | 485 |
| Fb 3 / PVK | 10 | 447 | 442 |
| Fb 3 / PVK+ PBD/PS | 12 | 436 | 443 |
| PL: Photolumineszenz EL: Elektrolumineszenz | | | |

Die Angaben in Tabelle 1 zeigen, daß sich mit den erfindungsgemäßen Blends unterschiedliche Elektrolumineszenzfarben einstellen lassen.

## Patentansprüche

1. Elektrolumineszierende Anordnungen, die mindestens 2 Elektroden und eine die lichtemittierende Schicht, die einen Farbstoff der Formel (I) und/oder (II) enthält, enthalten: 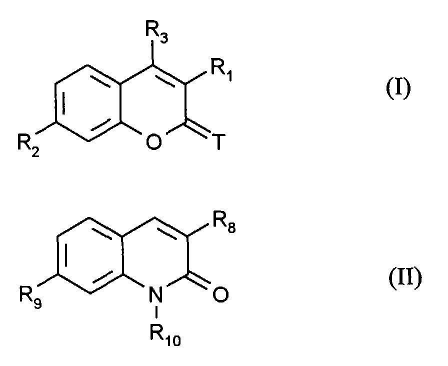 wobei
T für Sauerstoff oder NR₄ steht,
wobei
R₄ für Wasserstoff, gegebenenfalls substituiertes Alkyl oder gegebenenfalls substituiertes Aryl steht;
R₁ und R₈ ein über ein C-Atom gebundener carbo- oder heterocyclischer 5- oder 6-gliedriger Ring oder ein über ein N-Atom gebundener 5- oder 6-gliedriger heterocyclischer Ring bedeutet, der zu einer durch die Cumarin-N-Heterocyclus gelegten Achse rotationsunsymmetrisch ist, wobei die genannten 5- oder 6-gliedrigen Ringe nicht-ionogene Substituenten tragen können und an sie ein gegebenenfalls substituierter Benzol- oder ein gegebenenfalls substituierter Naphthalinring ankondensiert sein kann;
R₂ und R₉ gegebenenfalls substituiertes Alkyl, Alkenyl, gegebenenfalls substituiertes Cycloalkyl, gegebenenfalls substituiertes Aryl, gegebenenfalls substituiertes Aralkyl bedeutet oder für -O-R₅ oder für 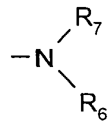 steht, wobei
R₅, R₆, R₇ oder R₁₀ gleich oder verschieden sein können und für Wasserstoff, gegebenenfalls substituiertes Alkyl oder gegebenenfalls substituiertes Aryl stehen.
R₃ für H oder CN steht.

2. Elektrolumineszierende Anordnung gemäß Anspruch 1, wobei
R₁ und R₈ für einen 5- oder 6-gliedrigen heterocyclischen Ring stehen, der 1, 2 oder 3 Heteroatome aus der Reihe N, O, S enthält und an den ein Benzolring ankondensiert sein kann, wobei sowohl der heterocyclische Ring wie auch der ankondensierte Benzolring durch Substituenten ausgewählt aus Alkyl, Aryl, Aralkyl, Cycloalkyl, Halogen, Alkoxy, Cyan und Acyl substituiert sein können.

3. Elektrolumineszierende Anordnung gemäß Anspruch 1, wobei Pyrazol, Imidazol, Thiazol, Oxazol, 1,2,4-Triazol, 1,3,4-Oxadiazol, 1,3,4-Thiadiazol, Benzimidazol, Benzthiazol, Benzoxazol oder Pyridin als 5- oder 6-gliedriger heterocyclischer Ring für R₁ und R₈, an den ein Benzolring ankondensiert sein kann, stehen.

4. Elektrolumineszierende Anordnung gemäß Anspruch 1, wobei R₁ und R₈ für einen heterocyclischen Rest der Formel (III) 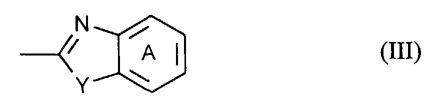 stehen, worin
Y Sauerstoff, Schwefel oder NR¹¹ bezeichnet, wobei
R¹¹ für Wasserstoff, Alkyl, Aryl, Cycloalkyl oder Aralkyl steht und der Ring A durch vorzugsweise 1 bis 2 Substituenten aus der Reihe C₁-C₄-Alkyl, C₁-C₄-Alkoxy, Brom, Chlor, Phenyl, Cyclohexyl, C₁-C₄-Alkylsulfonyl, Sulfamoyl oder C₁-C₄-Alkoxycarabonyl substituiert sein kann.

5. Elektrolumineszierende Anordnung, worin die folgenden Farbstoffe 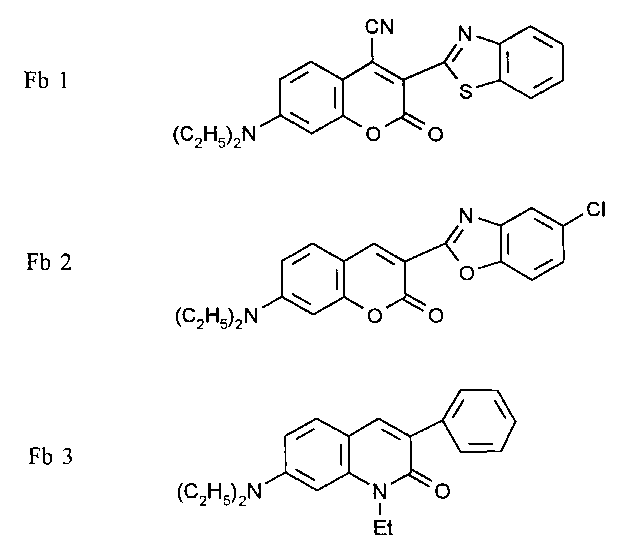 verwendet werden.

6. Elektrolumineszierende Anordnungen gemäß Anspruch 1, dadurch gekennzeichnet, daß die Anordnungen eine oder mehrere ladungsinjizierende Materialien enthalten.

7. Elektrolumineszierende Anordnungen gemäß Anspruch 1, dadurch gekennzeichnet, daß die Anordnungen eine oder mehrere ladungstransportierende Materialien enthalten.

8. Elektrolumineszierende Anordnungen gemäß Anspruch 1, dadurch gekennzeichnet, daß die ladungsinjizierenden Materialien in einer separaten Schicht angebracht sind.

9. Elektrolumineszierende Anordnungen gemäß Anspruch 1, dadurch gekennzeichnet, daß die ladungstransportierenden Materialien in einer separaten Schicht angebracht sind.

10. Verwendung der Farbstoffe aus Anspruch 5 in elektrolumineszierenden Anordnungen für Displays für Beleuchtungszwecke und Informationsdarstellung.
